# EUROPEAN PATENT APPLICATION

(11) **EP 4 459 644 A1**
(43) Date of publication of application: **06.11.2024**
(21) Application number: 23216166.1
(22) Date of filing: 13.12.2023
(51) Int. Cl.: H01F 17/00, H01F 17/04

(54) **THROUGH CORE VIA COAXIAL-TYPE INDUCTORS WITH TWO OR MORE MAGNETIC MATERIALS FOR POWER DELIVERY APPLICATIONS**

(30) Priority: 05.05.2023 US 202318143831
(71) Applicant: Intel Corporation, Santa Clara, CA 95054 (US)
(72) Inventor: ALEKSOV, Aleksandar, Chandler 85226 (US); BRAUNISCH, Henning, Phoenix 85018 (US); PRABHU GAUNKAR, Neelam, Chandler 85226 (US)
(74) Representative: 2SPL Patentanwälte PartG mbB

(57) **Abstract**

Embodiments disclosed herein include package substrates with integrated inductors. In an embodiment, a package substrate comprises a substrate and a via that passes through the substrate. In an embodiment, the via is electrically conductive. In an embodiment, a spacer is provided around the via. In an embodiment, a ring is around the spacer. In an embodiment, the ring comprises a magnetic material.

## Description

### TECHNICAL FIELD

Embodiments of the present disclosure relate to electronic systems, and more particularly, to electronic packages with coaxial inductors with two or more magnetic materials around an electrically conductive via.

### BACKGROUND

Power delivery passives (e.g., capacitors and inductors) for semiconductor dies are increasingly being moved into the core of the underlying package substrate. Moving the passives to the core reduces distance to the die and improves performance. In one such architecture, discrete passive components are embedded in the core. Embedded passive devices have several drawbacks. For example, planarity, stiffness, and homogeneity of the core is negatively impacted since large regions of the core material under the die will be replaced with the passives and an organic adhesive or encapsulant. Additionally, discrete devices may be sourced externally. This may lead to cost increases and/or supply chain issues.

An alternative approach is to use so called "integrated" passive devices. Integrated passive devices are passives that are fabricated directly in the package substrate. In one example, inductors can be fabricated into the core during assembly process flows. For example, an opening may be drilled through the core, and a magnetic paste is applied in the opening. The magnetic paste may then be drilled and a conductive via is plated within the magnetic paste. An architecture such as this may be referred to as a coaxial inductor since the magnetic material forms a ring around the conductive via. However, such solutions are lacking because magnetic pastes have relatively low relative permeabilities µᵣ (e.g., µᵣ values less than 10). This is because, at practical filling fractions, the relative permeability is dominated by the matrix material, which is non-magnetic. These low relative permeabilities put a hard limit on the scalability of such inductors. Magnetic via drill diameters may not go below approximately 350µm, and the pitch of such inductors may be limited to 550µm or greater. This limits the inductance density and the number of inductor and power phases that can be used for power delivery.

### BRIEF DESCRIPTION OF THE DRAWINGS

Figure 1A is a cross-sectional illustration of an inductor with a first ring and a second ring around a conductive via, in accordance with an embodiment.
Figure 1B is a cross-sectional illustration of the inductor that more clearly shows the coaxial nature of the inductor, in accordance with an embodiment.
Figure 2A is a cross-sectional illustration of an inductor with a first ring, a second ring, and an insulating plug within a conductive via, in accordance with an embodiment.
Figure 2B is a cross-sectional illustration of the inductor that more clearly shows the coaxial nature of the inductor, in accordance with an embodiment.
Figure 3 is a cross-sectional illustration of an inductor with a first ring that has a thickness that is less than a thickness of a second ring, in accordance with an embodiment.
Figure 4 is a cross-sectional illustration of an inductor with a spacer and a ring around the via, in accordance with an embodiment.
Figure 5A is a cross-sectional illustration of an inductor with a first seed layer for the magnetic rings, and a second seed layer for the via, in accordance with an embodiment.
Figure 5B is a cross-sectional illustration of an inductor with an insulating layer between rings and an insulating layer around the conductive via, in accordance with an embodiment.
Figure 6A is a cross-sectional illustration of an inductor with a ring that has a compositional gradient to provide a non-uniform relative permeability through a thickness of the ring, in accordance with an embodiment.
Figure 6B is a cross-sectional illustration of an inductor with a plurality of rings with increasing relative permeabilities, in accordance with an embodiment.
Figure 7 is a cross-sectional illustration of an inductor that includes portions provided past the top and bottom surface of the core, in accordance with an embodiment.
Figure 8 is a cross-sectional illustration of an electronic package that includes coaxial inductors with magnetic rings, in accordance with an embodiment.
Figures 9A-9F are cross-sectional illustrations depicting a process for forming a coaxial inductor in a core with a pair of magnetic rings, in accordance with an embodiment.
Figures 10A-10H are cross-sectional illustrations depicting a process for forming a coaxial inductor in a core with a pair of magnetic rings, in accordance with an additional embodiment.
Figure 11 is a cross-sectional illustration of an electronic system with integrated coaxial inductors in a core of a package substrate, in accordance with an embodiment.
Figure 12 is a schematic of a computing device built in accordance with an embodiment.

### EMBODIMENTS OF THE PRESENT DISCLOSURE

Described herein are electronic systems, and more particularly, electronic packages with coaxial inductors with two or more magnetic materials around an electrically conductive via, in accordance with various embodiments. In the following description, various aspects of the illustrative implementations will be described using terms commonly employed by those skilled in the art to convey the substance of their work to others skilled in the art. However, it will be apparent to those skilled in the art that the present invention may be practiced with only some of the described aspects. For purposes of explanation, specific numbers, materials and configurations are set forth in order to provide a thorough understanding of the illustrative implementations. However, it will be apparent to one skilled in the art that the present invention may be practiced without the specific details. In other instances, well-known features are omitted or simplified in order not to obscure the illustrative implementations.

Various operations will be described as multiple discrete operations, in turn, in a manner that is most helpful in understanding the present invention, however, the order of description should not be construed to imply that these operations are necessarily order dependent. In particular, these operations need not be performed in the order of presentation.

As noted above, integrated passive components are growing in importance as semiconductor dies (e.g., processors) become more power hungry. However, existing solutions do not enable the scaling necessary in order to reach the desired inductance density and/or current carrying capability. Accordingly, embodiments disclosed herein include integrated coaxial inductor architectures that are formed through the core of the package substrate. As used herein, an "integrated" inductor may refer to an inductor that is fabricated during the assembly of the package substrate. Examples of such integrated assembly processes are described in greater detail below.

More particularly, embodiments disclosed herein may include a dual ring structure around a conductive via. A first ring closer to the via may have a first relative permeability µᵣ and the second ring outside the first ring may have a second relative permeability µᵣ that is higher than the first relative permeability µᵣ. Such a configuration allows for the optimization of the inductance and current carrying capability.

While embodiments may include two magnetic rings, it is to be appreciated that embodiments are not limited to such configurations. For example, a single magnetic ring with a non-magnetic spacer between the ring and the via may be used in some embodiments. Additionally, two or more magnetic rings may be used to form a relative permeability gradient. Further, a single magnetic layer with a non-uniform composition through a thickness of the ring may be used to form a relative permeability gradient.

To provide context for the benefits of embodiments disclosed herein, it is to be appreciated that as distance from the conductive via increases, the magnetic field H decreases. The decreasing magnetic field H is more fully utilized through the use of at least two magnetic materials with different relative permeabilities µᵣ. The material with the lower relative permeability µᵣ of the inner ring may have a similar magnetic saturation Bₛ as the material of the outer ring, but the saturation occurs at relatively higher magnetic field H levels, since B is proportional to µᵣ times H. For the material with the higher relative permeability µᵣ of the outer ring the saturation occurs at relatively lower magnetic field H levels, compared to the inner ring. Accordingly, the high relative permeability µᵣ of the outer ring is spaced away from the conductive via so that the outer ring interacts with a weaker portion of the magnetic field H (which may still lead to complete magnetic saturation). Additionally, the low relative permeability µᵣ inner ring interacts with a stronger portion of the magnetic field H. The inner ring is more capable of using the higher magnetic field H strength to increase magnetic flux density B without going into saturation. As such, more maximized contributions to the total magnetic flux φ (and increased inductance L) can be provided by both the inner ring and the outer ring.

In addition to higher magnetic flux φ, embodiments disclosed herein provide improved current carrying capability per inductor element, compared to if a single high µᵣ material was used around the via. This allows for simpler inductor architecture (i.e., fewer inductors are needed in parallel), and improved inductance density.

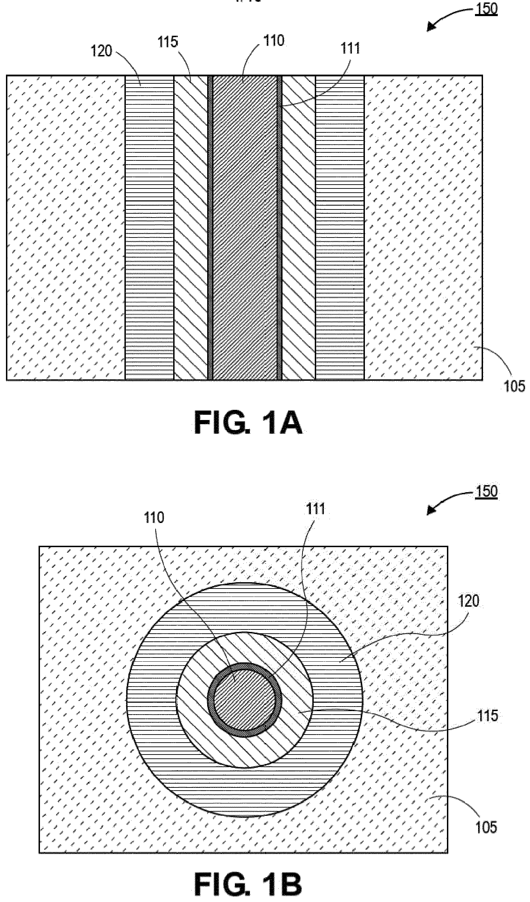

Referring now to Figure 1A, a cross-sectional illustration of an integrated inductor 150 is shown, in accordance with an embodiment. In an embodiment, the inductor 150 may be referred to as being a coaxial inductor 150. That is, a central via 110 may be surrounded by one or more rings (e.g., rings 115 and 120) in a coaxial configuration. The inductor 150 may be integrated in a substrate 105. More particularly, the substrate 105 may be a core of a package substrate. The substrate 105 may be any material suitable for use as a core. For example, the substrate 105 may comprise an organic core material, glass, ceramic (e.g., alumina), or the like. In an embodiment, the substrate 105 may have a thickness that is approximately 50µm or greater, or approximately 1,000µm or greater. Though, thinner substrates 105 may also be used in some embodiments. As used herein, "approximately" may refer to a range of values within ten percent of the stated value. For example, approximately 1,000µm may refer to a range between 900µm and 1,100µm.

In an embodiment, the via 110 may be an electrically conductive material. For example, the via 110 may be a copper via 110. The via 110 may be plated up from a seed layer 111. In the illustrated embodiment, the via 110 is fully plated in the opening and forms a cylindrical shape. This can be more clearly seen in the cross-section illustrated in Figure 1B. There, the via 110 has a solid circular shape that fills the space within an inner surface of the seed layer 111. In an embodiment, the seed layer 111 may comprise any suitable seed layer material or materials. For example, the seed layer 111 may comprise one or more of copper, titanium, ruthenium, tantalum, or the like. Multiple different materials may be provided in different layers (e.g., a layer of titanium covered by a layer of copper), or as an alloy. The seed layer 111 may have a thickness up to approximately 400nm in some embodiments.

In an embodiment, the inductor 150 may further comprise a first ring 115 and a second ring 120 that both surround the via 110. The first ring 115 and the second ring 120 may both be magnetic materials in some embodiments. More particularly, the first ring 115 may be a different magnetic material than the second ring 120. As shown in Figure 1B, the first ring 115 and the second ring 120 are concentric circles that surround the via 110.

The first ring 115 may have a first relative permeability µᵣ, and the second ring 120 may have a second relative permeability µᵣ. The second relative permeability µᵣ may be higher than the first relative permeability µᵣ. For example, the first ring 115 may have a first µᵣ that is between approximately 5 and approximately 250, and the second ring 120 may have a second µᵣ that is approximately 150 or above. In an embodiment, the first ring 115 may also have a magnetic saturation Bₛ that is lower than a magnetic saturation Bₛ of the second ring 120. For example, the first ring 115 may have a magnetic saturation Bₛ that is approximately 1T or lower. The magnetic saturations Bₛ of the second ring 120 may be between approximately 1.5T and approximately 3T. Though, it is to be appreciated that higher saturation materials may also be used for either the first ring 115 or the second ring 120, if available. In some embodiments, the first ring 115 and the second ring 120 may have high resistivities. For example, resistivities of approximately 100Ωcm or higher, or even 10,000µΩcm or higher may be possible.

In an embodiment, the magnetic materials used for the inner first ring 115 and the outer second ring 120 may be any magnetic materials that provide properties such as those described above. In one embodiment, the high µᵣ second ring 120 may comprise an alloy of cobalt, nickel, and iron (e.g., CoNiFe). Compositional variances between the individual Co, Ni, and Fe constituents may be used to provide desired magnetic properties. In some embodiments, dopants such as one or more of boron, oxygen, sulfur, sulfur and oxygen, vanadium and oxygen, phosphorus, and phosphorus and oxygen, may be included in the CoNiFe material composition. Alternative materials for the second ring 120 may include cobalt and iron (e.g., CoFe) at various stoichiometries, or CoFeX (where X can be phosphorous, boron, sulfur, or oxygen). Other materials may include an alloy of nickel, zinc, and iron (e.g., NiZnFe), a permalloy (e.g., NiFe), or an alloy of cobalt, zirconium, and tantalum (e.g., CoZrTa (CZT)).

In an embodiment, the low µᵣ first ring 115 may comprise a material similar to those described above where the stoichiometry leads to a lower µᵣ. For example, CoNiFe, CoNiFeX, CoFe, CoFeX materials may be used for the first ring 115. Additionally, ferrites such as one comprising nickel, zinc, iron, and oxygen (e.g., NiZnFeO) may be used. The first ring 115 may also be formed with a magnetic paste material. That is, an organic matrix material (e.g., epoxy, polyimides, etc.) that is filled with magnetic particles may be used in some embodiments.

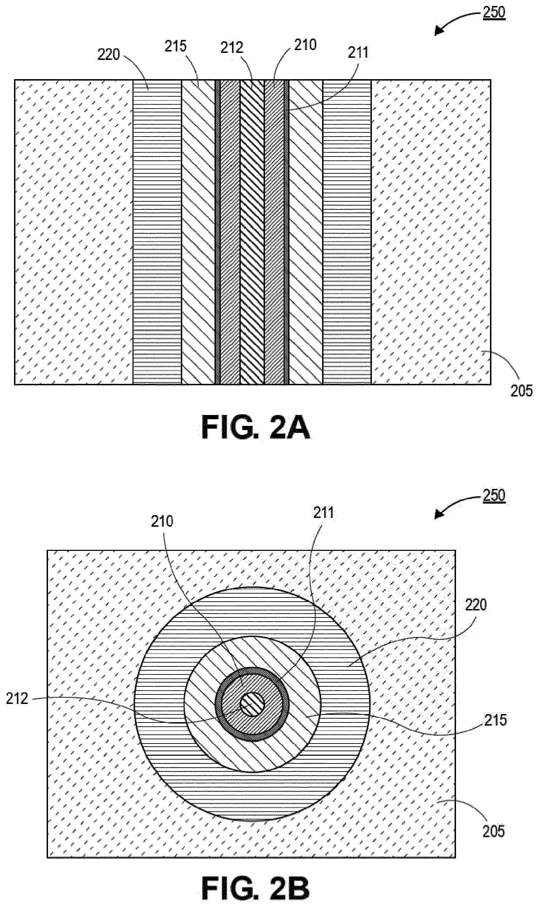

Referring now to Figure 2A, a cross-sectional illustration of an integrated inductor 250 is shown, in accordance with an additional embodiment. The inductor 250 may be formed through a substrate 205. The substrate 205 may be substantially similar to the substrate 105 described above. In an embodiment, the inductor 250 comprises a first ring 215 and a second ring 220 that are formed around via 210. The first ring 215 and the second ring 220 may be similar to the first ring 115 and the second ring 120 described above.

A seed layer 211 may be used to plate the via 210. Instead of fully filling the remainder of the opening in the substrate 205, the via 210 is partially plated. As shown in Figure 2B, the via 210 is another ring. The space adjacent to the inner surface of the via 210 may be filled with a non-magnetic and electrically insulating plug material 212, such as an epoxy or the like.

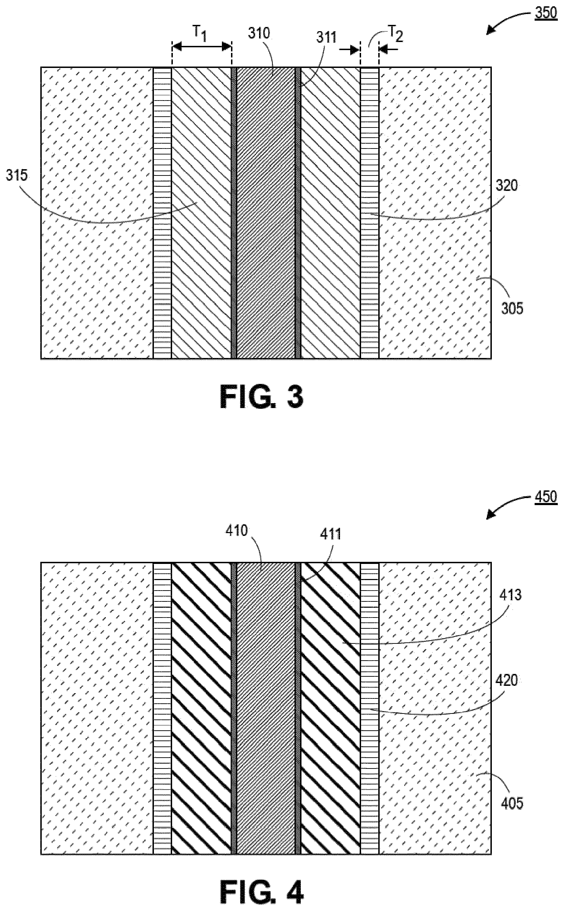

Referring now to Figure 3, a cross-sectional illustration of an integrated inductor 350 is shown, in accordance with an embodiment. In an embodiment, the inductor 350 may be formed in a substrate 305. The substrate 305 may be similar to the substrate 105 described above. The inductor 350 may include a conductive via 310, such as a copper via 310. In the illustrated embodiment, the via 310 is a solid feature (e.g., a cylinder). Though, in other embodiments the via 310 may be a shell with an insulating plug, similar to the embodiment shown in Figure 2A. A seed layer 311 may form a ring around the via 310.

In an embodiment, a first ring 315 and a second ring 320 may surround the via 310. The first ring 315 and the second ring 320 may be magnetic materials. The first ring 315 may have a first µᵣ and the second ring 320 may have a second µᵣ. The second µᵣ may be greater than the first µᵣ. Materials for the first ring 315 and the second ring 320 may be similar to materials for rings 115 and 120 described in greater detail above.

In an embodiment, the thickness of the first ring 315 may be different than a thickness of the second ring 320. For example, a first thickness T₁ of the first ring 315 may be larger than a second thickness T₂ of the second ring 320. Though, in some embodiments, T₁ may be substantially equal to T₂, or T₂ may be larger than T₁. In a particular embodiment, the first thickness T₁ may be between approximately 1µm and approximately 50µm, and the second thickness T₂ may be between approximately 0.5µm and approximately 15µm.

Referring now to Figure 4, a cross-sectional illustration of an integrated inductor 450 is shown, in accordance with an embodiment. The inductor 450 may be formed in a substrate 405. The substrate 405 may be similar to the substrate 105 described in greater detail above. In an embodiment, a via 410 may pass through a thickness of the substrate 405. The via 410 may be a solid shape (e.g., a cylinder) or a shell with an insulating plug (e.g., similar to the via 210 in Figure 2A). The via 410 may be lined by a seed layer 411.

In an embodiment, a spacer 413 may surround the via 410. The spacer 413 may be an insulating material. Further, the spacer 413 may be non-magnetic in some embodiments. For example, the spacer may comprise silicon and oxygen or any other suitable insulating material. The purpose of the spacer 413 is to move the magnetic ring 420 away from the via 410 so that the magnetic ring 420 interacts with a lower magnetic field B. The spacer 413 may have a thickness that sets the magnetic ring 420 away from the via 410 by a distance that allows for the magnetic ring 420 to become fully saturated. The magnetic ring 420 may be a high µᵣ material similar to any of the magnetic materials described in greater detail above.

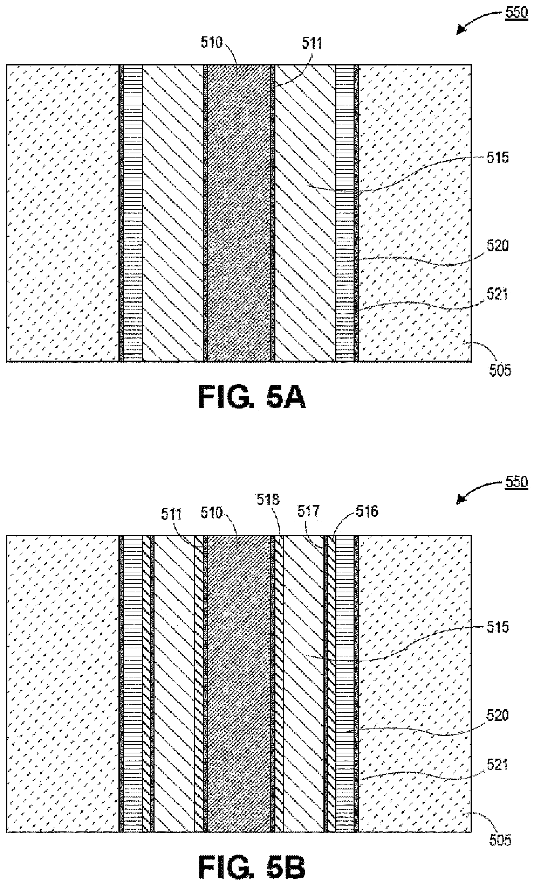

Referring now to Figure 5A, a cross-sectional illustration of an integrated inductor 550 is shown, in accordance with an additional embodiment. As shown, the inductor 550 is provided in a substrate 505, similar to substrate 105 described in greater detail above. In an embodiment, the inductor 550 may comprise a via 510 that is surrounded by a seed layer 511. The via 510 may be a solid structure, or the via 510 may be a shell with an insulating plug (similar to the via 210 in Figure 2A).

In an embodiment, the inductor 550 may further comprise a first ring 515 and a second ring 520. The first ring 515 and the second ring 520 may be magnetic materials. In a particular embodiment, the first ring 515 may have a relatively low µᵣ and the second ring 520 may have a relatively high µᵣ. Materials for the first ring 515 and the second ring 520 may be similar to any of the magnetic materials described in greater detail above.

In an embodiment, a seed layer 521 may be provided around a perimeter of the second ring 520. The seed layer 521 may comprise one or more of copper, titanium, ruthenium, tantalum, or the like. Multiple different materials may be provided in different layers (e.g., a layer of titanium covered by a layer of copper), or as an alloy. The seed layer 521 may have a thickness up to approximately 400nm in some embodiments. The outer seed layer 521 allows for the second ring 520 to be plated with an electroplating process.

Referring now to Figure 5B, a cross-sectional illustration of an integrated inductor 550 is shown, in accordance with an additional embodiment. In the embodiment shown in Figure 5B, insulating layers 516 and 518 may be provided between layers. For example, insulating layer 516 is between the first ring 515 and the second ring 520, and insulating layer 518 is between the via 510 and the first ring 515. The insulating layers 516 and 518 may aid in the prevention of eddy currents passing between the layers. Since an insulating layer 516 is provided along an inner surface of the second ring 520, a seed layer 517 may be used to plate the first ring 515. The seed layer 517 may be similar to any of the seed layers described in greater detail herein.

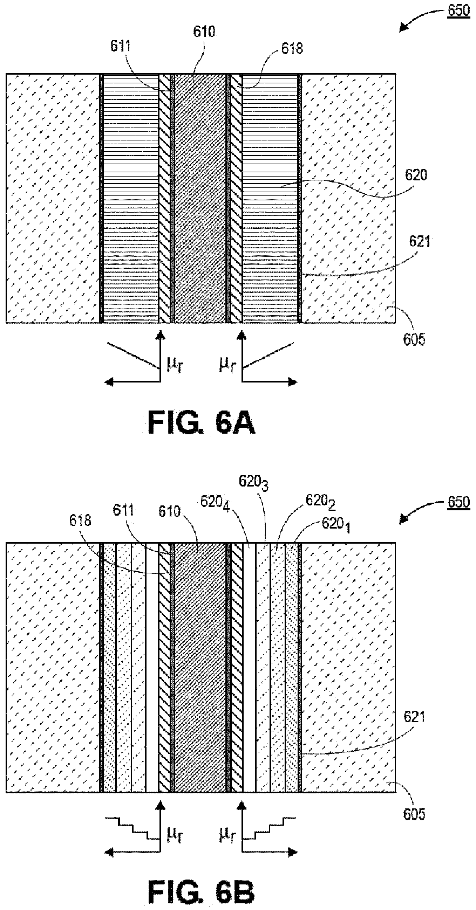

Referring now to Figure 6A, a cross-sectional illustration of an integrated inductor 650 is shown, in accordance with an additional embodiment. In an embodiment, the inductor 650 comprises a via 610 through a substrate 605. The substrate 605 and the via 610 may be similar to any of the vias or substrates described in greater detail above. The via 610 may be lined with a seed layer 611. In an embodiment, an insulating spacer 618 may be formed around the seed layer 611.

In an embodiment, a magnetic ring 620 may be formed around the insulating spacer 618. The magnetic ring 620 may have a compositional gradient across a thickness of the ring 620. The compositional gradient may result in a non-uniform µᵣ through the thickness of the ring 620. For example, as shown in the graphs below the inductor 650, µᵣ starts low at the interface with the insulating spacer 618 and increases up to the interface with the outer seed layer 621. While the µᵣ profile is shown as having a linear increase, it is to be appreciated that the µᵣ profile may have any shape so long as µᵣ increases between the inner surface of the ring 620 and the outer surface of the ring 620. Such a graded material may be made by modifying plating parameters during the plating of the ring 620.

Referring now to Figure 6B, a cross-sectional illustration of an integrated inductor 650 is shown, in accordance with an additional embodiment. In Figure 650, the graded ring 620 is replaced by a plurality of rings 620₁ - 620₄. Each ring 620 may have a different µᵣ. Particularly, the µᵣ of ring 620₁ is the highest, followed by the µᵣ of ring 620₂, followed by the µᵣ of ring 620₃, and the µᵣ of ring 620₄ is the lowest. As shown in the graphs below the inductor 650, the variation in µᵣ may be a stepwise function. In the illustrated embodiment, each of the rings 620₁ - 620₄ have a uniform thickness. Though, in other embodiments the rings 620₁-620₄ may have non-uniform thicknesses.

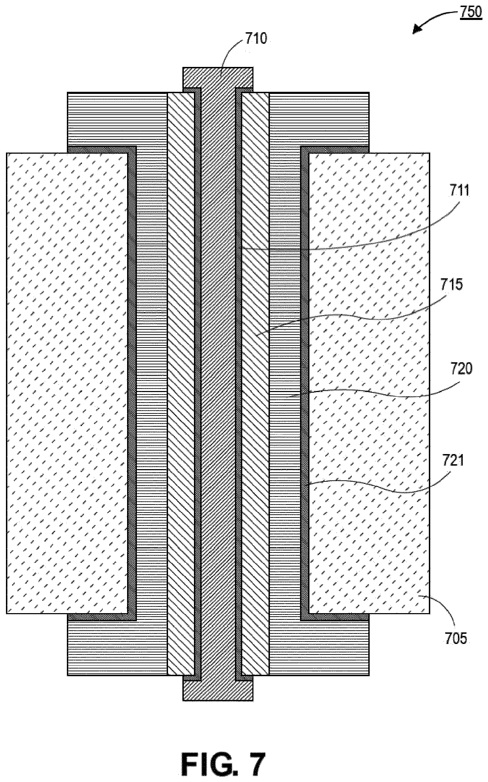

Referring now to Figure 7, a cross-sectional illustration of an integrated inductor 750 is shown, in accordance with an embodiment. In the previous embodiments, the inductors are shown only through the substrate. The embodiment shown in Figure 7 illustrates that some portions of the inductor may be provided over a top and bottom surface of the substrate 705 as well. For example, seed layer 721 may line an opening through the substrate 705 and wrap along the top and bottom surface of the substrate 705. As such, the plated second ring 720 may also be formed over portions of the top and bottom surface of the substrate 705. The first ring 715 may be entirely within an opening of the second ring 720. That is, the first ring 715 may not have any horizontal portions. In an embodiment, the seed layer 711 may wrap around the top and bottom surface of the first ring 715. This provides a via 710 that has pad shaped top and bottom portions where the pads are wider than the main vertical length of the via 710.

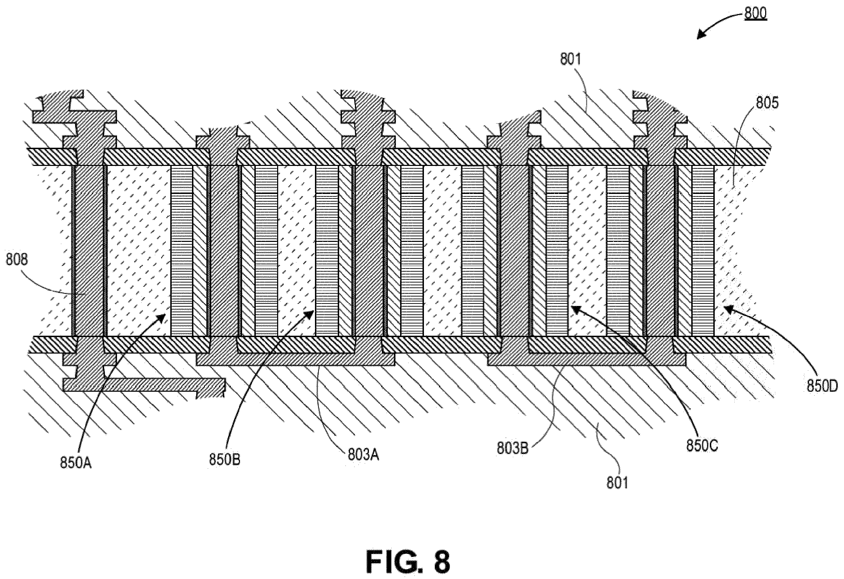

Referring now to Figure 8, a cross-sectional illustration of a package substrate 800 is shown, in accordance with an embodiment. The package substrate 800 may comprise a core 805 with buildup layers 801 above and below the core 805. The core 805 may be a glass core, a ceramic core, or an organic core. In an embodiment, the buildup layers 801 may be organic buildup film or the like.

In an embodiment, a plurality of inductors 850 are provided through a thickness of the core 805. Further, the inductors 850 may be electrically coupled together in some embodiments. For example, inductor 850A and inductor 850B are coupled together in series by trace 803A, and inductor 850C and inductor 850D are coupled together in series by trace 803B. While shown as being in series, it is to be appreciated that inductors 850 may also be coupled to each other in parallel, or in series and in parallel, depending on the inductance needs of the device. Vias 808 without any magnetic material (such as vias for signal propagation) may also be provided through the core 805 in some embodiments. Pads, traces, vias, and the like may also be included in the buildup layers 801 to provide electrical routing within the package substrate 800.

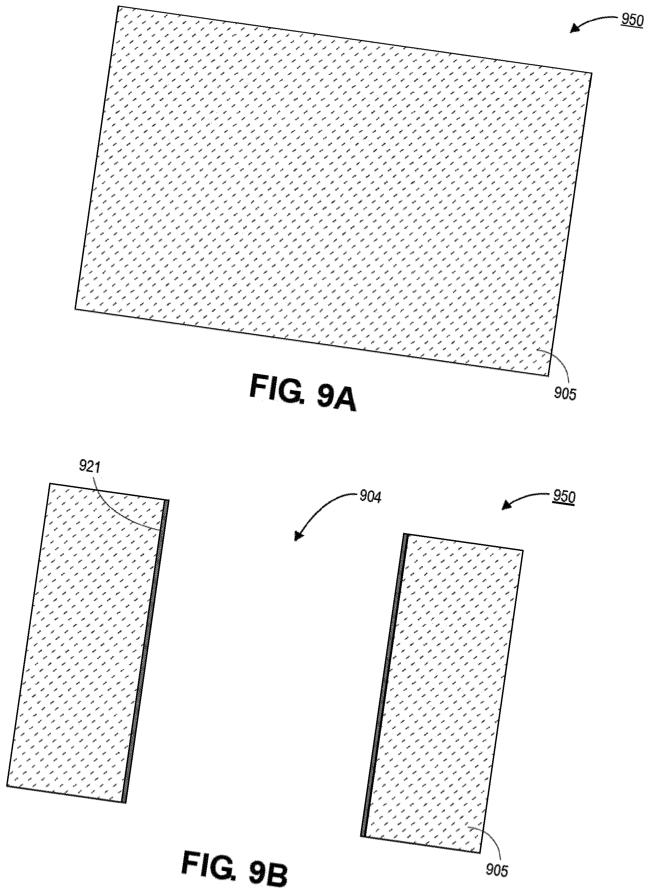

Referring now to Figures 9A-9F, a series of cross-sectional illustrations depicting a process for forming an integrated inductor 950 is shown, in accordance with an embodiment. In an embodiment, the inductor 950 may be similar to the inductor 550 shown in Figure 5A. Though, it is to be appreciated that inductors with any structure described herein may be formed using similar processes.

Referring now to Figure 9A, a cross-sectional illustration of an integrated inductor 950 at a stage of manufacture is shown, in accordance with an embodiment. In an embodiment, a substrate 905 is provided. The substrate 905 may be a core of a package substrate. For example, the substrate 905 may be a glass core, a ceramic core, or an organic core. In an embodiment, a thickness of the substrate 905 may be approximately 50µm or greater or approximately 1,000µm or greater.

Referring now to Figure 9B, a cross-sectional illustration of the inductor 950 after an opening 904 is formed through the substrate 905 is shown, in accordance with an embodiment. The opening 904 may be formed with any subtractive process. For example, a mechanical drilling process, a laser drilling process, an etching process, or any combination thereof may be used to form the opening 904. In the illustrated embodiment, the opening 904 has substantially vertical sidewalls. Though, some material removal processes may result in tapered sidewalls. In an embodiment, a seed layer 921 is provided along the sidewalls of the opening 904. The seed layer 921 may be similar to any of the seed layers described in greater detail above.

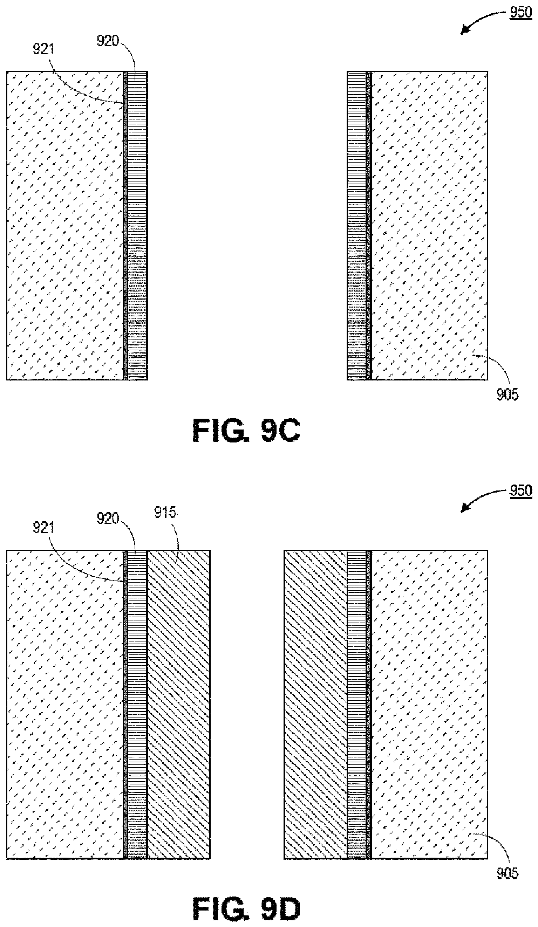

Referring now to Figure 9C, a cross-sectional illustration of the inductor 950 after a second ring 920 is plated is shown, in accordance with an embodiment. In an embodiment, the second ring 920 may be plated with an electrolytic plating process or the like. The second ring 920 may be a magnetic material. More particularly, the second ring 920 may be a magnetic material with a relatively high µᵣ.

Referring now to Figure 9D, a cross-sectional illustration of the inductor 950 after a first ring 915 is plated is shown, in accordance with an embodiment. As shown, the first ring 915 is directly on the second ring 920. Though, it is to be appreciated that an insulating layer and a seed layer may also be provided between the first ring 915 and the second ring 920. In an embodiment, the first ring 915 is also a magnetic material. More particularly, the first ring 915 is a magnetic material with a relatively low µᵣ compared to the second ring 920.

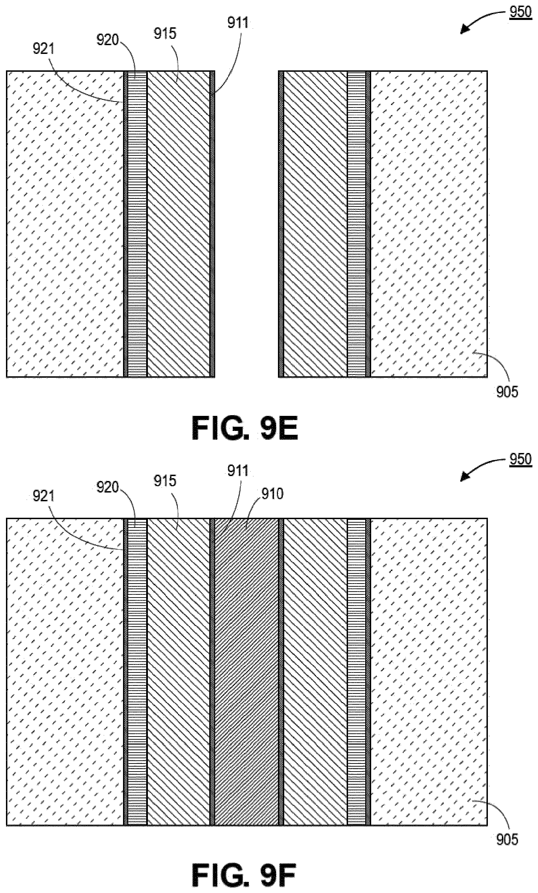

Referring now to Figure 9E, a cross-sectional illustration of the inductor 950 after a seed layer 911 is applied along an inner surface of the first ring 915 is shown, in accordance with an embodiment. In an embodiment, the seed layer 911 may be directly on the first ring 915. In other embodiments, an insulating layer may be provided between the seed layer 911 and the first ring 915. The seed layer 911 may be similar to any of the seed layers described in greater detail above.

Referring now to Figure 9F, a cross-sectional illustration of the inductor 950 after a via 910 is plated is shown, in accordance with an embodiment. As shown, the via 910 is fully plated to form a cylindrical shape. Though, in other embodiments, the via 910 may be a shell with an insulating plug in the middle. The via 910 may be plated with an electroplating process.

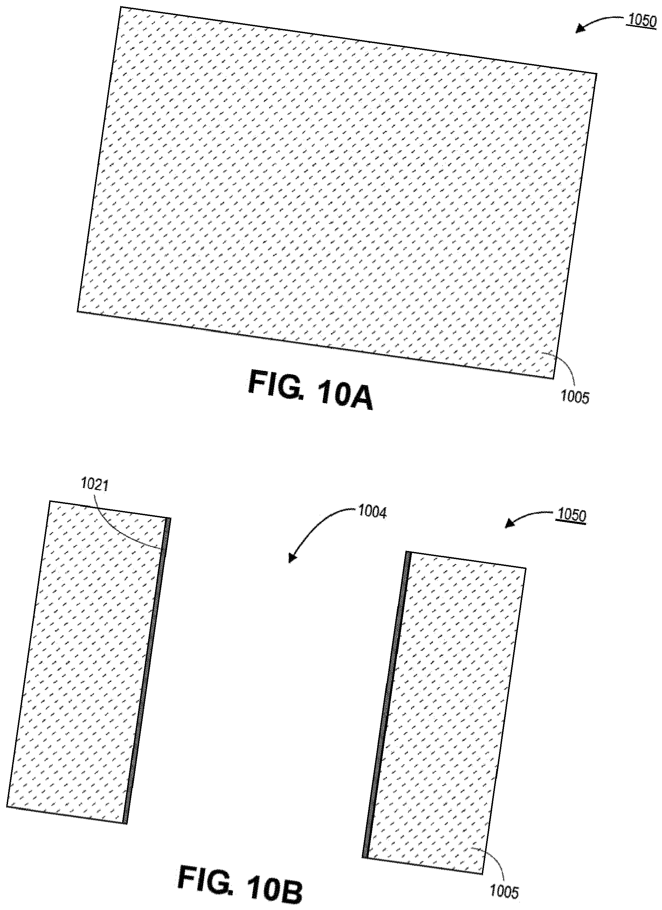

Referring now to Figures 10A-10H, a series of cross-sectional illustrations depicting an alternative way to form an integrated inductor is shown, in accordance with an embodiment.

Referring now to Figure 10A, a cross-sectional illustration of an integrated inductor 1050 at a stage of manufacture is shown, in accordance with an embodiment. In an embodiment, a substrate 1005 is provided. The substrate 1005 may be a core of a package substrate. For example, the substrate 1005 may be a glass core, a ceramic core, or an organic core. In an embodiment, a thickness of the substrate 1005 may be approximately 50µm or greater or approximately 1,000µm or greater.

Referring now to Figure 10B, a cross-sectional illustration of the inductor 1050 after an opening 1004 is formed through the substrate 1005 is shown, in accordance with an embodiment. The opening 1004 may be formed with any subtractive process. For example, a mechanical drilling process, a laser drilling process, an etching process, or any combination thereof may be used to form the opening 1004. In the illustrated embodiment, the opening 1004 has substantially vertical sidewalls. Though, some material removal processes may result in tapered sidewalls. In an embodiment, a seed layer 1021 is provided along the sidewalls of the opening 1004. The seed layer 1021 may be similar to any of the seed layers described in greater detail above.

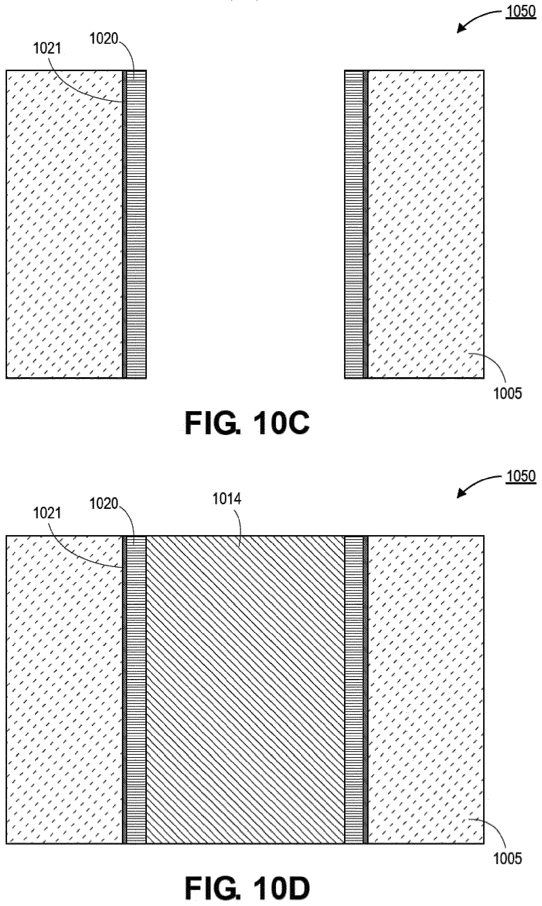

Referring now to Figure 10C, a cross-sectional illustration of the inductor 1050 after a second ring 1020 is plated is shown, in accordance with an embodiment. In an embodiment, the second ring 1020 may be plated with an electrolytic plating process or the like. The second ring 1020 may be a magnetic material. More particularly, the second ring 1020 may be a magnetic material with a relatively high µᵣ.

Referring now to Figure 10D, a cross-sectional illustration of the inductor 1050 after a magnetic plug 1014 fills the opening within the second ring 1020 is shown, in accordance with an embodiment. The magnetic plug 1014 may be an organic matrix with magnetic particles distributed through the matrix. In an embodiment, the magnetic plug 1014 has a relatively low µᵣ compared to the second ring 1020. While shown as being in direct contact with the second ring 1020, some embodiments may include an insulating layer between the magnetic plug 1014 and the second ring 1020.

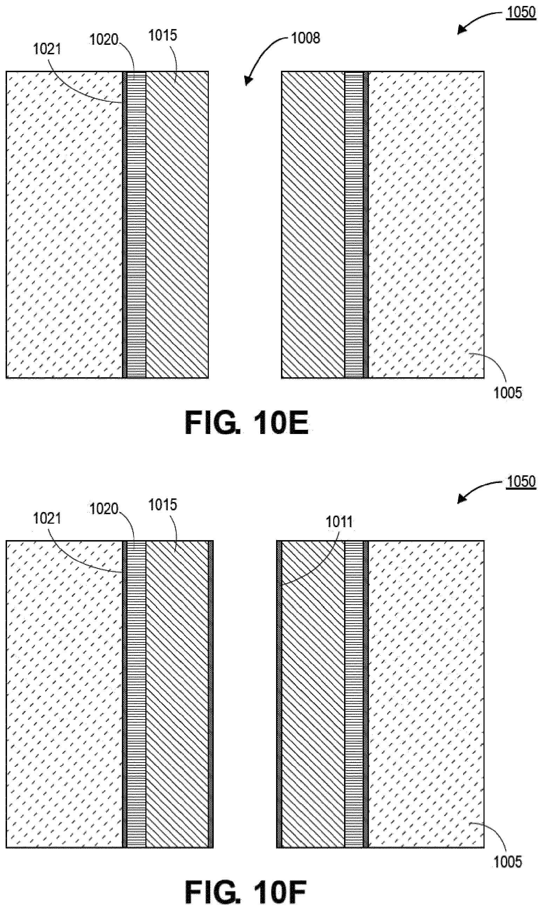

Referring now to Figure 10E, a cross-sectional illustration of the inductor 1050 after an opening 1008 is formed through the magnetic plug 1014 to form a first ring 1015 is shown, in accordance with an embodiment. In an embodiment, the opening 1008 may be formed with a drilling process, such as a mechanical drilling process.

Referring now to Figure 10F, a cross-sectional illustration of the inductor 1050 after a second seed layer 1011 is applied over the interior surface of the first ring 1015 is shown, in accordance with an embodiment. The seed layer 1011 may be directly on the first ring 1015, or an insulating layer may be provided between the first ring 1015 and the seed layer 1011. The seed layer 1011 may be similar to any of the seed layers described in greater detail above.

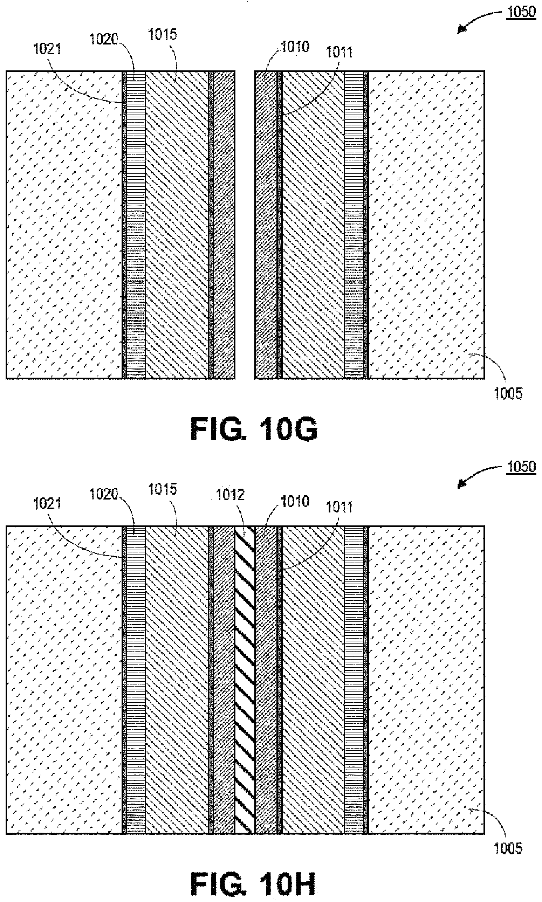

Referring now to Figure 10G, a cross-sectional illustration of the inductor 1050 after a via 1010 is plated up from the seed layer 1011 is shown, in accordance with an embodiment. The via 1010 may be plated with an electrolytic plating process or the like. In an embodiment, the plating of the via 1010 may not completely fill the opening. That is, the via 1010 may be a shell in some embodiments. Though, in other embodiments, the via 1010 may fully fill the opening.

Referring now to Figure 10H, a cross-sectional illustration of the inductor 1050 after an insulating plug 1012 is provided within the via 1010 is shown, in accordance with an embodiment. In an embodiment, the plug 1012 may be any insulating material, such as an epoxy or the like.

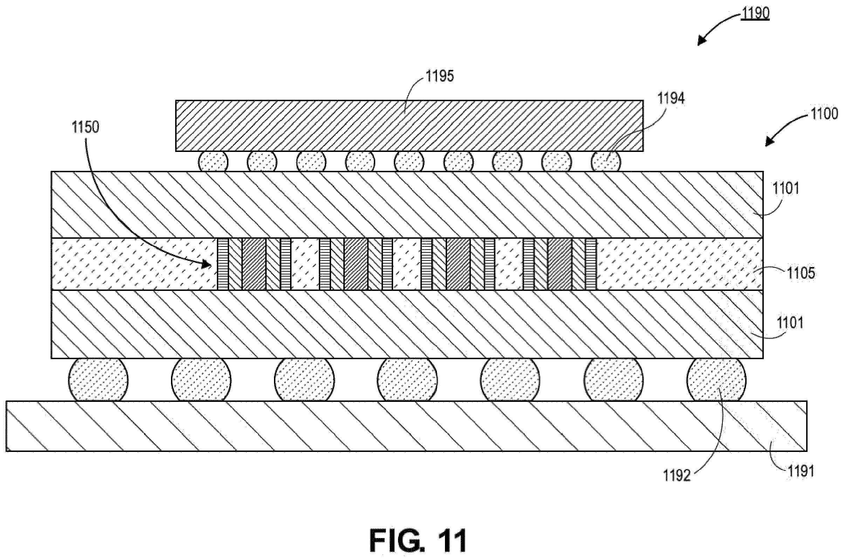

Referring now to Figure 11, a cross-sectional illustration of an electronic system 1190 is shown, in accordance with an embodiment. In an embodiment, the electronic system 1190 comprises a board 1191, such as a printed circuit board (PCB). The board 1191 may be coupled to a package substrate 1100 by interconnects 1192, such as solder balls, sockets, or the like.

In an embodiment, the package substrate 1100 comprises a core 1105 with buildup layers 1101 above and below the core 1105. The core 1105 may comprise a glass material, a ceramic material, or an organic material. In an embodiment, one or more integrated inductors 1150 are provided through the core 1105. The inductors 1150 may be similar to any of the inductor structures described in greater detail herein. For example, the inductors 1150 may have a via, a first magnetic ring with a relatively low µᵣ, and a second magnetic ring with a relatively high µᵣ.

In an embodiment, one or more dies 1195 may be coupled to the package substrate 1100 through interconnects 1194. The interconnects 1194 may be solder balls or any other first level interconnect (FLI) architecture. In an embodiment, the die 1195 may be a compute die, such as a central processing unit (CPU), a graphics processing unit (GPU), an XPU, a system on a chip (SoC), a communications die, a memory die, or the like.

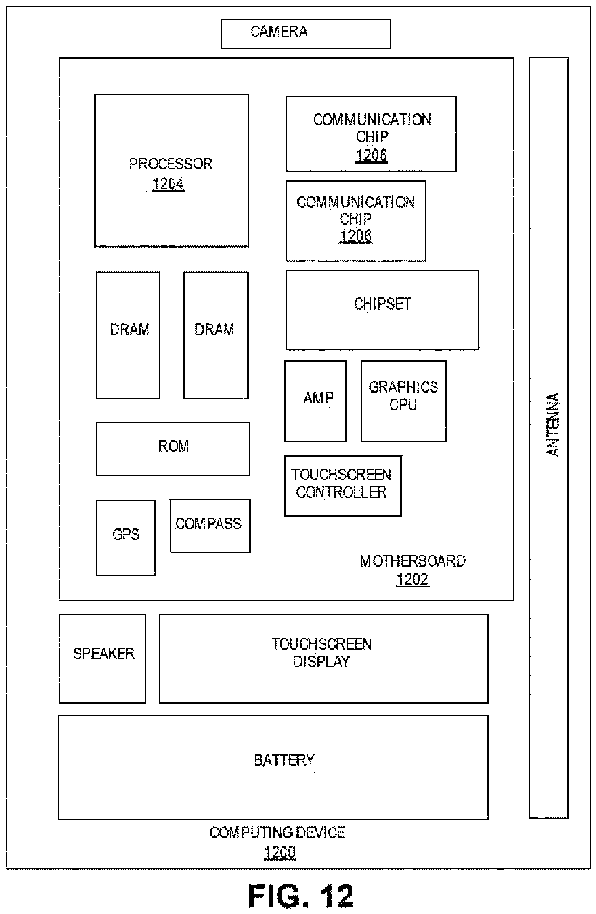

Figure 12 illustrates a computing device 1200 in accordance with one implementation of the invention. The computing device 1200 houses a board 1202. The board 1202 may include a number of components, including but not limited to a processor 1204 and at least one communication chip 1206. The processor 1204 is physically and electrically coupled to the board 1202. In some implementations the at least one communication chip 1206 is also physically and electrically coupled to the board 1202. In further implementations, the communication chip 1206 is part of the processor 1204.

These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 1206 enables wireless communications for the transfer of data to and from the computing device 1200. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 1206 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 1200 may include a plurality of communication chips 1206. For instance, a first communication chip 1206 may be dedicated to shorter range wireless communications such as Wi-Fi and Bluetooth and a second communication chip 1206 may be dedicated to longer range wireless communications such as GPS, EDGE, GPRS, CDMA, WiMAX, LTE, Ev-DO, and others.

The processor 1204 of the computing device 1200 includes an integrated circuit die packaged within the processor 1204. In some implementations of the invention, the integrated circuit die of the processor may be part of an electronic package with integrated inductors within the core that have a first magnetic ring with a low µᵣ and a second magnetic ring with a high µᵣ, in accordance with embodiments described herein. The term "processor" may refer to any device or portion of a device that processes electronic data from registers and/or memory to transform that electronic data into other electronic data that may be stored in registers and/or memory.

The communication chip 1206 also includes an integrated circuit die packaged within the communication chip 1206. In accordance with another implementation of the invention, the integrated circuit die of the communication chip may be part of an electronic package with integrated inductors within the core that have a first magnetic ring with a low µᵣ and a second magnetic ring with a high µᵣ, in accordance with embodiments described herein.

In an embodiment, the computing device 1200 may be part of any apparatus. For example, the computing device may be part of a personal computer, a server, a mobile device, a tablet, an automobile, or the like. That is, the computing device 1200 is not limited to being used for any particular type of system, and the computing device 1200 may be included in any apparatus that may benefit from computing functionality.

The above description of illustrated implementations of the invention, including what is described in the Abstract, is not intended to be exhaustive or to limit the invention to the precise forms disclosed. While specific implementations of, and examples for, the invention are described herein for illustrative purposes, various equivalent modifications are possible within the scope of the invention, as those skilled in the relevant art will recognize.

These modifications may be made to the invention in light of the above detailed description. The terms used in the following claims should not be construed to limit the invention to the specific implementations disclosed in the specification and the claims. Rather, the scope of the invention is to be determined entirely by the following claims, which are to be construed in accordance with established doctrines of claim interpretation.

Example 1: a package substrate comprising: a substrate; a via that passes through the substrate, wherein the via is electrically conductive; a spacer around the via; and a ring around the spacer, wherein the ring comprises a magnetic material.

Example 2: the package substrate of Example 1, wherein the spacer is a second magnetic material, and wherein the ring has a first relative permeability and the spacer has a second relative permeability, wherein the first relative permeability is higher than the second relative permeability.

Example 3: the package substrate of Example 1 or Example 2, wherein the magnetic material has a magnetic saturation of approximately 1.5T or higher.

Example 4: the package substrate of Examples 1-3, wherein a relative permeability of the ring is approximately 100 or greater, and wherein a second relative permeability of the spacer is approximately 200 or less.

Example 5: the package substrate of Examples 1-4, wherein a thickness of the spacer is substantially equal to a thickness of the ring.

Example 6: the package substrate of Examples 1-5, wherein a thickness of the spacer is greater than a thickness of the ring.

Example 7: the package substrate of Examples 1-6, further comprising: an insulating layer between the spacer and the ring.

Example 8: the package substrate of Examples 1-7, further comprising: an insulating layer between the via and the spacer.

Example 9: the package substrate of Examples 1-8, wherein the ring has a graded relative permeability, wherein an outer surface of the ring has a higher relative permeability than an inner surface of the ring.

Example 10: the package substrate of Examples 1-9, further comprising: a plurality of rings around the spacer, wherein each ring has a different relative permeability, and wherein a relative permeability of an outer ring is greater than a relative permeability of an inner ring.

Example 11: the package substrate of Examples 1-10, wherein the substrate is a package core, and wherein the package core comprises a glass, a ceramic, or an organic core material.

Example 12: a package substrate, comprising: a core; an inductor through the core, wherein the inductor comprises: a via, wherein the via is electrically conductive; a first ring around the via, wherein the first ring comprises a first relative permeability; and a second ring around the first ring, wherein the second ring comprises a second relative permeability, wherein the second relative permeability is higher than the first relative permeability; and buildup layers over and under the core.

Example 13: the package substrate of Example 12, further comprising: a second inductor through the core.

Example 14: the package substrate of Example 13, wherein the inductor and the second inductor are connected in series electrically.

Example 15: the package substrate of Example 13, wherein the inductor and the second inductor are connected in parallel electrically.

Example 16: the package substrate of Examples 12-15, wherein the core comprises a glass, a ceramic, or an organic core material.

Example 17: the package substrate of Examples 12-16, further comprising: an insulting plug through a center of the via.

Example 18: an electronic system, comprising: a board; a package substrate coupled to the board, wherein the package substrate comprises: a core; and an inductor through the core, wherein the inductor comprises: a via; a spacer around the via; and a ring around the spacer, wherein the ring has a relative permeability that is approximately 100 or greater; and a die coupled to the package substrate.

Example 19: the electronic system of Example 18, wherein the spacer is magnetic and wherein a relative permeability of the spacer is lower than the relative permeability of the ring.

Example 20: the electronic system of Example 18 or Example 19, wherein the electronic system is part of a personal computer, a server, a mobile device, a tablet, or an automobile.

## Claims

1. A package substrate comprising:
a substrate;
a via that passes through the substrate, wherein the via is electrically conductive;
a spacer around the via; and
a ring around the spacer, wherein the ring comprises a magnetic material.

2. The package substrate of claim 1, wherein the spacer is a second magnetic material, and wherein the ring has a first relative permeability and the spacer has a second relative permeability, wherein the first relative permeability is higher than the second relative permeability.

3. The package substrate of claim 1 or 2, wherein the magnetic material has a magnetic saturation of approximately 1.5T or higher.

4. The package substrate of claim 1, 2 or 3, wherein a relative permeability of the ring is approximately 100 or greater, and wherein a second relative permeability of the spacer is approximately 200 or less.

5. The package substrate of claim 1, 2, 3 or 4, wherein a thickness of the spacer is substantially equal to a thickness of the ring.

6. The package substrate of claim 1, 2, 3, 4 or 5, wherein a thickness of the spacer is greater than a thickness of the ring.

7. The package substrate of claim 1, 2, 3, 4, 5 or 6, further comprising:
an insulating layer between the spacer and the ring.

8. The package substrate of claim 1, 2, 3, 4, 5, 6 or 7, further comprising:
an insulating layer between the via and the spacer.

9. The package substrate of claim 1, 2, 3, 4, 5, 6, 7 or 8, wherein the ring has a graded relative permeability, wherein an outer surface of the ring has a higher relative permeability than an inner surface of the ring.

10. The package substrate of claim 1, 2, 3, 4, 5, 6, 7, 8 or 9, further comprising:
a plurality of rings around the spacer, wherein each ring has a different relative permeability, and wherein a relative permeability of an outer ring is greater than a relative permeability of an inner ring.

11. The package substrate of claim 1, 2, 3, 4, 5, 6, 7, 8, 9 or 10, wherein the substrate is a package core, and wherein the package core comprises a glass, a ceramic, or an organic core material.

12. A method of fabricating a package substrate, the method comprising:
forming a via that passes through a substrate, wherein the via is electrically conductive;
forming a spacer around the via; and
forming a ring around the spacer, wherein the ring comprises a magnetic material.

13. The method of claim 12, wherein the spacer is a second magnetic material, and wherein the ring has a first relative permeability and the spacer has a second relative permeability, wherein the first relative permeability is higher than the second relative permeability.

14. The method of claim 12 or 13, wherein the magnetic material has a magnetic saturation of approximately 1.5T or higher.

15. The method of claim 12, 13 or 14, wherein a relative permeability of the ring is approximately 100 or greater, and wherein a second relative permeability of the spacer is approximately 200 or less.
